# EUROPEAN PATENT SPECIFICATION

(11) **EP 3 270 174 B1**
(45) Date of publication and mention of the grant of the patent: **24.11.2021**
(21) Application number: 17275097.8
(22) Date of filing: 03.07.2017
(51) Int. Cl.: G01R 31/08, G01R 31/11

(54) **TEST ARRANGEMENT**
PRÜFANORDNUNG
AGENCEMENT DE TEST

(30) Priority: 06.07.2016 GB 201611775
(43) Date of publication of application: 17.01.2018
(73) Proprietor: Viper Innovations Ltd, Portishead Bristol BS20 7AW (GB)
(72) Inventor: SIMPSON, Steve, Bristol, Somerset BS20 7AW (GB); OVERTON, Paul Robert, Portishead, North Somerset BS20 7LS (GB)
(74) Representative: Somervell, Thomas Richard

(56) References cited:
- EP-A2- 0 704 365
- EP-A2- 2 339 359
- WO-A1-98/08104
- GB-A- 2 462 001
- US-A1- 2012 245 880
- US-A1- 2015 077 131
- US-A1- 2016 033 583

## Description

This invention relates to a test arrangement, and in particular to a test arrangement operable to monitor the status of an elongate electrical cable or the like, or cable sections that together form an elongate cable.

Long electrical cables, for example of length in the region of several kilometres, are used in a number of applications. One application in which they are found is in the power circuits used in controlling the operation of railway signalling systems. In such applications, power from the cables is used to control the operation of trackside signals, and/or to provide control signals for use in controlling, for example, the movement of track points, points heating systems, rolling stock recognition systems and the like. As the safe and timely operation of railway vehicles is dependent upon the signalling system operating correctly and reliably, it is desirable for the status of the cables used in the system to be monitored. Some of the parameters that it is desirable to monitor are the electrical continuity or resistance of the cables. A loss of continuity may indicate that the cable is broken or has become disconnected. Clearly, this would lead to a loss of control over the operation of parts of the system and so is undesirable. As such a loss of control may lead to trains being halted until such time as the fault is remedied, it is desirable for the presence of the fault, and the location thereof, to be established rapidly so that repair thereof can be attended to. Other parameters that may be monitored include the insulation resistance and capacitance, a loss of which may result in short circuits, preventing the correct operation of the signalling system.

Typically, in a railway signalling power circuit, a series of functional points are provided at which a distribution voltage at which electrical power is distributed along power cables is stepped down to a voltage suitable for use in powering trackside equipment or the like.

Whilst railway signalling arrangements represent one application in which elongate cables are used, and in which monitoring thereof is desirable, the invention may be employed in a number of other applications. By way of example, it may be employed in the monitoring of power cables for road side equipment, elongate communications lines and in a number of other applications.

Where cables are deployed in subsea locations, then it is known to use line insulation monitoring equipment to check the status of the insulation so that the presence and location of failures can be identified and rectified in an efficient manner, reducing or minimising periods in which equipment controlled via the cables is rendered inoperable. The cables with which such equipment is used are typically of relatively short length. EP0704365 describes an arrangement in which the status of a communications cable can be checked, periodically, at intervals along its length using a series of sensor modules, the outputs of which are communicated to one another and to a remote location. WO98/08104 and US2015/0377131 also describe test arrangements. US2016/033583A1 discloses a system to identify potential faults in an electrical power distribution system. GB2462001A discloses a fault detection and restoration system.

It is an object of the invention to provide a test arrangement whereby the status of an elongate cable can be monitored.

According to the present invention there is provided a test arrangement for use in monitoring the status of an elongate cable as defined by appended Claim and a test method as defined by appended Claim 14.

The cable may have a number of functional points connected thereto spaced apart along the length thereof. Each test module may be located within or associated with a respective one of the function points.

It will be appreciated that the cable may be made up of a number of cable sections, each interconnecting a pair of the function points.

Each test module preferably takes the form of a monitoring apparatus operable to monitor the resistance and/or electrical continuity of the cable.

Such an arrangement is advantageous in that if a fault develops in the cable, by analysis of the outputs of the test modules, the presence of the fault and the approximate location of the fault can be identified.

The distributed communications network may comprise a wired network, an optical fibre based communications network, or alternatively may take the form of a wireless communications network. Indeed, it could comprise a mix wired, optical fibre and wireless parts, if desired.

The elongate cable may take the form of a cable used in the control of a railway signalling arrangement. Accordingly, in a second aspect of the invention, a railway signalling arrangement is provided comprising an elongate cable whereby control and/or power signals are supplied to trackside equipment, and a test arrangement for use in monitoring the status of the elongate cable, the test arrangement comprising a plurality of test modules installed, in use, at intervals along a length of the cable, the modules communicating with at least a control unit via a distributed communications network.

The invention will further be described, by way of example, with reference to the accompanying drawings, in which:
Figure 1 is a diagrammatic representation of part of a power supply arrangement for a typical railway signalling system; and
Figure 2 illustrates, diagrammatically, part of a power supply arrangement monitored using a test arrangement in accordance with an embodiment of the invention.

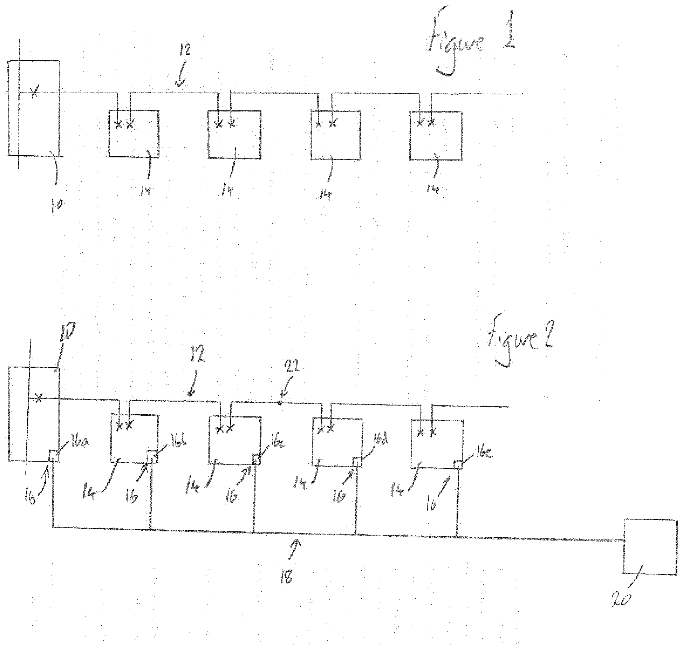

Referring firstly to Figure 1, part of a typical power supply arrangement for a railway signalling system is illustrated. The arrangement comprises a trackside principal supply point 10 operable to supply electrical power and control signals via a cable 12 to a series of functional supply points 14 arranged in series. The cable 12 is made up of a number of cable sections, each interconnecting a pair of the points 10, 14. The separation of the principal supply point 10 and the functional supply points 14 may be such that the lengths of the sections of cable 12 may be in the region of, for example, a few hundred metres to several kilometres. The principal supply point 10 is operable to convert an incoming electrical supply, for example a 400V supply, to a distribution voltage (typically in the region of 650V) for distribution via the cable 12 to the functional supply points 14. The functional supply points 14 may take the form of transformers operable to step down the supply voltage from the distribution level to, for example, 110V for use in controlling the operation of, for example, trackside signal lights providing information to train drivers of whether or not the track ahead of the train is clear, or information regarding the setting of points or the like, in the vicinity of the functional supply point 14, or to heat track points. Alternatively, the equipment supplied via the functional supply points 14 may take the form of control units whereby the operation of track points are controlled. However, it will be appreciated that this does not represent an exhaustive list of functionality provided by the equipment powered by the functional supply points. Other functionality may include, for example, control arrangements for use in controlling the operation of level crossings, controls for controlling the operation of track or points heaters, and arrangements operable to monitor for broken tracks, the presence of trains and the like.

It will be appreciated from the description above that the cable 12 is typically arranged to carry a 650V single phase supply between the principal supply point 10 and the functional supply points 14 via electrically isolated, unearthed cables.

In accordance with the invention, as illustrated in the embodiment shown in Figure 2, within the principal supply point 10 and each of the functional supply points 14 is located a test module 16. Each test module 16 takes the form of a monitoring apparatus connected in such a fashion as to allow each test module 16 to independently test the condition or status of the part of the cable 12 upstream of the respective module 16 and the part of the cable 12 downstream of the respective module 16. The parameters monitored by the modules 16 may include the electrical resistance and/or continuity of the monitored parts of the cable 12. In addition, the line insulation may be monitored, and other parameters detected. By way of example, time domain reflectometry (TDR) techniques, and in particular spread spectrum TDR (SSTDR) techniques, could be employed to aid fault location. In such an arrangement, a suitable filter may be provided to control the direction in which the tests are undertaken. The modules 16 are each connected to a distributed communications network 18 to which a control unit 20 is also connected such that the control unit 20 is able to receive information output by each of the modules 16. There is no need for the modules 16 to communicate with one another, communication with the control unit 20 being sufficient.

The precise form of each module 16 and manner in which it operates to detect the presence of a fault is not of relevance to the invention and so is not described herein in further detail. Preferably, each module 16 is constantly connected to the cable 12, rather than being connected periodically via, for example, a switched connection. Accordingly, monitoring may be undertaken substantially continuously rather than just being undertaken periodically.

The communications network 18 may take a range of forms. By way of example, each module 16 may communicate with the control unit 20 via wired connections or optical fibres running alongside the railway tracks. Alternatively, communication may be by way of a wireless communications link. Indeed, the network 18 may include different types of communications link in different parts thereof, if desired. Again, it will be appreciated that the invention is not restricted to a specific type of network architecture, and the nature of the network 18 is not described herein in further detail.

In the arrangement shown in Figure 2, when the cable is fault-free, the signals supplied to the control unit 20 via the network 18 from each module 16 will indicate that the cable 12 is functional both upstream and downstream of each module 16. In the event that the cable 12 is broken at point 22, for example, then the test modules 16a, 16b and 16c will each be outputting signals via the network 18 to the control unit 20 to indicate that the part of the cable 12 upstream of the respective module 16 is functioning correctly, but that there is a fault in the part of the cable 12 downstream thereof. The test modules 16d, 16e (and any further test module 16 downstream thereof) will output signals that there is fault upstream of the respective module 16, but that the part of the cable 12 downstream thereof is functional. Based upon this information, the control unit 20 is able to identify not only that a fault is present but also that the fault is located on the part of the cable 12 located between test modules 16c and 16d. Armed with this information, maintenance engineers may be sent to inspect that part of the cable 12 to identify the precise location of the fault and to attend to repair thereof.

It will be appreciated that the invention is advantageous in that in the event of a fault, not only is the existence of the fault flagged up to a controller, but also the approximate location of the fault is identified. As a result, the fault can be rectified considerably more quickly than would be the case if the maintenance engineers had to inspect the full length of the cable 12 to identify the location of the fault.

As shown in Figures 1 and 2, the connections between the cable 12 and each point 10, 14 may be switched connections, allowing parts of the signalling arrangement to be isolated from other parts thereof. By way of example, such isolation may be undertaken when parts of the arrangement are undergoing servicing, maintenance or inspection. As the modules 16 will detect the presence of an open switch in the same manner as they will detect a break or failure in the cable 12, the outputs of the modules 16 may be used to provide a confirmation that the correct part of the arrangement has been isolated before the servicing operations or the like are undertaken.

Whilst Figure 2 illustrates the invention in use in a signalling arrangement in which a number of functional supply points 14 are connected to one another in series, in some arrangements the functional supply points 14 may be connected to one another in other configurations, and the invention may be employed in such arrangements to provide an indication of the status of the cable 12 thereof. By way of example, the functional supply points 14, or at least some of the functional supply points 14, may be arranged in a radial feed configuration. Furthermore, two or more principal supply points 10 may be provided, for example at opposite ends of the cable 12. In such an arrangement, the switches will be controlled in such a fashion that none of the points 14 receive power simultaneously from both points 10, but control over the switch positions can be used to allow continued operation of the arrangement in the event of, for example, a failure of one of the points 10. It will be appreciated that these are merely examples of configurations in which the invention may be employed, and that the invention is not restricted in this regard.

Whilst a specific embodiment of the invention is described herein, a range of modifications and alterations may be made thereto without departing from the scope of the invention as defined by the appended claims.

## Claims

1. A test arrangement for use in monitoring the status of an elongate cable (12), the arrangement comprising a plurality of test modules (16) installed, in use, at intervals along a length of the cable (12), each of the test modules comprising a monitoring apparatus operable to monitor the insulation resistance of the cable either or both of upstream or downstream of the location at which the monitoring apparatus is installed, and the modules (16) communicating with at least a control unit (20) via a distributed communications network (18), such that the control unit is configured to receive information output by the test modules wherein the received information indicates whether the cable is functional upstream and/or downstream of the location in which that module (16) is installed, the control unit (20) using the outputs of the modules (16) in combination to identify the presence of and approximate location of a fault in the cable (12) based on the monitored insulation resistance.

2. A test arrangement according to claim 1, wherein the monitoring apparatus is additionally operable to monitor the electrical continuity of the cable.

3. An arrangement according to any preceding claim, wherein the cable (12) has a number of function points (14) connected thereto spaced apart along the length thereof, and each test module (16) is located within or associated with a respective one of the function points (14).

4. An arrangement according to Claim 3, wherein the cable (12) is made up of a number of cable sections, each interconnecting a pair of the function points (14).

5. An arrangement according to any of the preceding claims, wherein the distributed communications network (18) comprises a wired network.

6. An arrangement according to any of the preceding claims, wherein the distributed communications network (18) comprises a fibre optic based network.

7. An arrangement according to any of the preceding claims, wherein the network (18) comprises a wireless communications network.

8. An arrangement according to any of the preceding claims, wherein each test module (16) is operable to undertake capacitance measurements on the cable.

9. An arrangement according to any of the preceding claims, wherein each test module (16) is operable to undertake time domain reflectometry (TDR) based tests on the cable.

10. An arrangement according to Claim 9, wherein the time domain reflectometry (TDR) based tests are spread spectrum time domain reflectometry (SSTDR) based tests.

11. An arrangement according to Claim 9 or Claim 10, further comprising filter means to restrict the directionality with which the time domain reflectometry (TDR) based tests are undertaken.

12. An arrangement according to any of the preceding claims, wherein the elongate cable (12) takes the form of a power cable.

13. An arrangement according to Claim 12, where in power cable is used in the control of the operation of at least part of a railway signalling system.

14. A test method for use in monitoring the status of an elongate cable (12), the method comprising providing a test arrangement according to any of the preceding claims, and using the outputs supplied from the test modules (16) in combination to identify the presence and approximate location of a fault in the elongate cable (12).

## Patentansprüche

1. Prüfanordnung zur Verwendung beim Überwachen des Zustands eines länglichen Kabels (12), wobei die Anordnung eine Mehrzahl von Prüfmodulen (16) umfasst, welche, im Betrieb, in Intervallen entlang der Länge des Kabels (12) installiert sind, wobei jedes der Prüfmodule eine Überwachungsvorrichtung umfasst, welche betreibbar ist, um den Isolierwiderstand des Kabels stromaufwärts und/oder stromabwärts der Stelle zu überwachen, an welcher die Überwachungsvorrichtung installiert ist, und die Module (16) mit mindestens einer Steuerungseinheit (20) über ein verteiltes Kommunikationsnetzwerk (18) kommunizieren, derart, dass die Steuerungseinheit konfiguriert ist, um Informationen zu empfangen, die von den Prüfmodulen ausgegeben werden, wobei die empfangenen Informationen angeben, ob das Kabel stromaufwärts und/oder stromabwärts der Stelle funktionsfähig ist, an welcher das Modul (16) installiert ist, wobei die Steuerungseinheit (20) die Ausgaben der Module (16) in Kombination verwendet, um die Anwesenheit und die annähernde Position eines Fehlers in dem Kabel (12) basierend auf dem überwachten Isolierwiderstand zu identifizieren.

2. Prüfanordnung nach Anspruch 1, wobei die Überwachungsvorrichtung zusätzlich betreibbar ist, um die elektrische Kontinuität des Kabels zu überwachen.

3. Anordnung nach einem der vorhergehenden Ansprüche, wobei das Kabel (12) eine Anzahl von Funktionspunkten (14) aufweist, welche damit entlang seiner Länge beabstandet verbunden sind, und wobei jedes Prüfmodul (16) innerhalb eines entsprechenden der Funktionspunkte (14) angeordnet oder diesem zugeordnet ist.

4. Anordnung nach Anspruch 3, wobei das Kabel (12) aus einer Anzahl von Kabelabschnitten besteht, welche jeweils ein Paar von Funktionspunkten (14) miteinander verbinden.

5. Anordnung nach einem der vorhergehenden Ansprüche, wobei das verteilte Kommunikationsnetzwerk (18) ein drahtgebundenes Netzwerk umfasst.

6. Anordnung nach einem der vorhergehenden Ansprüche, wobei das verteilte Kommunikationsnetzwerk (18) ein glasfaserbasiertes Netzwerk umfasst.

7. Anordnung nach einem der vorhergehenden Ansprüche, wobei das Netzwerk (18) ein drahtloses Kommunikationsnetzwerk umfasst.

8. Anordnung nach einem der vorhergehenden Ansprüche, wobei jedes Prüfmodul (16) betreibbar ist, um Kapazitätsmessungen auf dem Kabel auszuführen.

9. Anordnung nach einem der vorhergehenden Ansprüche, wobei jedes Prüfmodul (16) betreibbar ist, um Prüfungen basierend auf Zeitbereichsreflektometrie (TDR) an dem Kabel auszuführen.

10. Anordnung nach Anspruch 9, wobei die Prüfungen basierend auf Zeitbereichsreflektometrie (TDR) Prüfungen sind, die auf Spreizspektrum-Zeitbereichsreflektometrie (SSTDR) basieren.

11. Anordnung nach Anspruch 9 oder Anspruch 10, ferner umfassend Filtermittel, um die Direktionalität zu begrenzen, mit welcher die Prüfungen basierend auf Zeitbereichsreflektometrie (TDR) ausgeführt werden.

12. Anordnung nach einem der vorhergehenden Ansprüche, wobei das längliche Kabel (12) die Form eines Leistungskabels aufweist.

13. Anordnung nach Anspruch 12, wobei das Leistungskabel bei der Steuerung des Betriebs von mindestens einem Teil eines Eisenbahn-Signalisierungssystems verwendet wird.

14. Prüfverfahren zur Verwendung bei dem Überwachen des Zustands eines länglichen Kabels (12), wobei das Verfahren das Bereitstellen einer Prüfanordnung nach einem der vorhergehenden Ansprüche und das Verwenden der von den Prüfmodulen (16) bereitgestellten Ausgaben in Kombination, um die Anwesenheit und annähernde Position eines Fehlers in dem länglichen Kabel (12) zu identifizieren, umfasst.

## Revendications

1. Agencement de test destiné à être utilisé pour surveiller l'état d'un câble allongé (12), l'agencement comprenant une pluralité de modules de test (16) installés lors du fonctionnement à des intervalles le long d'une longueur du câble (12), chacun des modules de test comprenant un appareil de surveillance pouvant être exécuté pour surveiller la résistance d'isolement du câble, en amont et/ou en aval de l'emplacement au niveau duquel l'appareil de surveillance est installé, et les modules (16) communiquant avec au moins une unité de commande (20) par l'intermédiaire d'un réseau de communications réparti (18), de sorte que l'unité de commande est configurée pour recevoir des informations émises par les modules de test, dans lequel les informations reçues indiquent si le câble est fonctionnel en amont et/ou en aval de l'emplacement où ce module (16) est installé, l'unité de commande (20) utilisant les sorties des modules (16) en combinaison pour identifier la présence et l'emplacement approximatif d'un défaut dans le câble (12) sur la base de la résistance d'isolement surveillée.

2. Agencement de test selon la revendication 1, dans lequel l'appareil de surveillance peut en outre être exécuté pour surveiller la continuité électrique du câble.

3. Agencement de test selon l'une quelconque des revendications précédentes, dans lequel le câble (12) comporte un certain nombre de points de fonctions (14) qui y sont connectés, espacés le long de sa longueur, et chaque module de test (16) est disposé dans l'un respectif des points de fonctions (14) ou associé à celui-ci.

4. Agencement selon la revendication 3, dans lequel le câble (12) est formé à partir d'un certain nombre de sections de câble, chacune reliant une paire de points de fonctions (14).

5. Agencement selon l'une quelconque des revendications précédentes, dans lequel le réseau de communications réparti (18) comprend un réseau câblé.

6. Agencement selon l'une quelconque des revendications précédentes, dans lequel le réseau de communications réparti (18) comprend un réseau à base de fibres optiques.

7. Agencement selon l'une quelconque des revendications précédentes, dans lequel le réseau (18) comprend un réseau de communications sans fil.

8. Agencement selon l'une quelconque des revendications précédentes, dans lequel chaque module de test (16) peut être exécuté pour effectuer des mesures de capacité sur le câble.

9. Agencement selon l'une quelconque des revendications précédentes, dans lequel chaque module de test (16) peut être exécuté pour effectuer des tests basés sur la de réflectométrie à dimension temporelle (TDR) sur le câble.

10. Agencement selon la revendication 9, dans lequel les tests basés sur la réflectométrie à base temporelle (TDR) sont des tests basés sur la réflectométrie à dimension temporelle à spectre étalé (SSTDR).

11. Agencement selon la revendication 9 ou 10, comprenant en outre des moyens de filtre pour restreindre la directionnalité avec laquelle les tests basés sur la réflectométrie à dimension temporelle sont effectués.

12. Agencement selon l'une quelconque des revendiquions précédentes, dans lequel le câble allongé (12) a la forme d'un câble d'alimentation.

13. Agencement selon la revendication 12, dans lequel le câble d'alimentation est utilisé dans la commande du fonctionnement d'au moins une partie d'un système de signalisation de chemin de fer.

14. Procédé de test destiné à être utilisé pour surveiller l'état d'un câble allongé (12), le procédé comprenant les étapes de fourniture d'un agencement de test selon l'une quelconque des revendications précédentes et d'utilisation des sorties fournies par les modules de test (16) en combinaison pour identifier la présence et l'emplacement approximatif d'un défaut dans le câble allongé (12).
